# FASCICULE DE BREVET EUROPEEN

(11) **EP 1 673 785 B1**
(45) Date de publication et mention de la délivrance du brevet: **16.05.2007**
(21) Numéro de dépôt: 04817228.2
(22) Date de dépôt: 18.10.2004
(51) Int. Cl.: G21K 1/06, H05G 2/00

(54) **SOURCE A PLASMA DE RAYONS DIRIGES ET APPLICATION A LA MICROLITHOGRAPHIE**
PLASMAQUELLE GERICHTETER STRAHLEN UND ANWENDUNG DAFÜR IN DER MIKROLITHOGRAPHIE
PLASMA SOURCE OF DIRECTED BEAMS AND APPLICATION THEREOF TO MICROLITHOGRAPHY

(30) Priorité: 17.10.2003 FR 0312202
(43) Date de publication de la demande: 28.06.2006
(73) Titulaire: EPPRA, 91140 Villebon sur Yvette (FR)
(72) Inventeur: CHOI, Peter, F-91400 Orsay (FR)
(74) Mandataire: Le Forestier, Eric
(86) Numéro de dépôt international: PCT/FR2004/002656
(87) Numéro de publication internationale: WO 2005/038822

(56) Documents cités:
- EP-A- 0 528 542
- US-A- 4 219 705
- US-A- 5 812 631
- US-A1- 2001 055 364
- US-A1- 2002 021 782
- US-A1- 2003 058 429
- BORISOV A B ET AL: "Relativistic and charge-displacement self-channeling of intense ultrashort laser pulses in plasmas" PHYS. REV. A, STAT. PHYS. PLASMAS FLUIDS RELAT. INTERDISCIP. TOP. (USA), PHYSICAL REVIEW A (STATISTICAL PHYSICS, PLASMAS, FLUIDS, AND RELATED INTERDISCIPLINARY TOPICS), USA, vol. 45, no. 8, 15 avril 1992 (1992-04-15), pages 5830-5845, XP002285829 ISSN: 1050-2947
- BOLTON P R ET AL: "Propagation of intense, ultrashort laser pulses through preionized plasma slabs" J. OPT. SOC. AM. B, OPT. PHYS. (USA), JOURNAL OF THE OPTICAL SOCIETY OF AMERICA B (OPTICAL PHYSICS), OPT. SOC. AMERICA, USA, vol. 14, no. 2, février 1997 (1997-02), pages 437-443, XP002285830 ISSN: 0740-3224
- TSUDA N ET AL: "Physical properties of dense plasma produced by XeCl excimer laser in high-pressure argon gases" JPN. J. APPL. PHYS. 1, REGUL. PAP. SHORT NOTES REV. PAP. (JAPAN), JAPANESE JOURNAL OF APPLIED PHYSICS, PART 1 (REGULAR PAPERS, SHORT NOTES & REVIEW PAPERS), PUBLICATION OFFICE, JAPANESE JOURNAL APPL. PHYS, JAPAN, vol. 38, no. 6A, juin 1999 (1999-06), pages 3712-3715, XP002285831 ISSN: 0021-4922

## Description

La présente invention concerne la génération d'un rayonnement de longueurs d'onde désirées.

Plus précisément, l'invention concerne un procédé de génération dans une direction d'émission d'un rayonnement dans une gamme de longueurs d'onde désirées, ledit procédé comprenant :
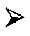 La production d'un rayonnement initial par une source de rayonnement, dont les longueurs d'onde incluent ladite gamme désirée,
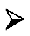 Le filtrage dudit rayonnement initial, de manière à substantiellement éliminer les rayons du rayonnement initial dont la longueur d'onde est hors de ladite gamme désirée.

Et l'invention concerne également un dispositif de génération de rayonnement permettant de mettre en oeuvre un tel procédé, ainsi qu'un dispositif de lithographie intégrant un tel dispositif de génération.

On connaît déjà des procédés et dispositifs du type mentionné ci-dessus.

Un exemple (non limitatif) de mise en oeuvre concerne ainsi la génération d'un rayonnement de longueurs d'onde désirées à destination d'une chaîne optique, pour des applications de lithographie d'un substrat photosensible.

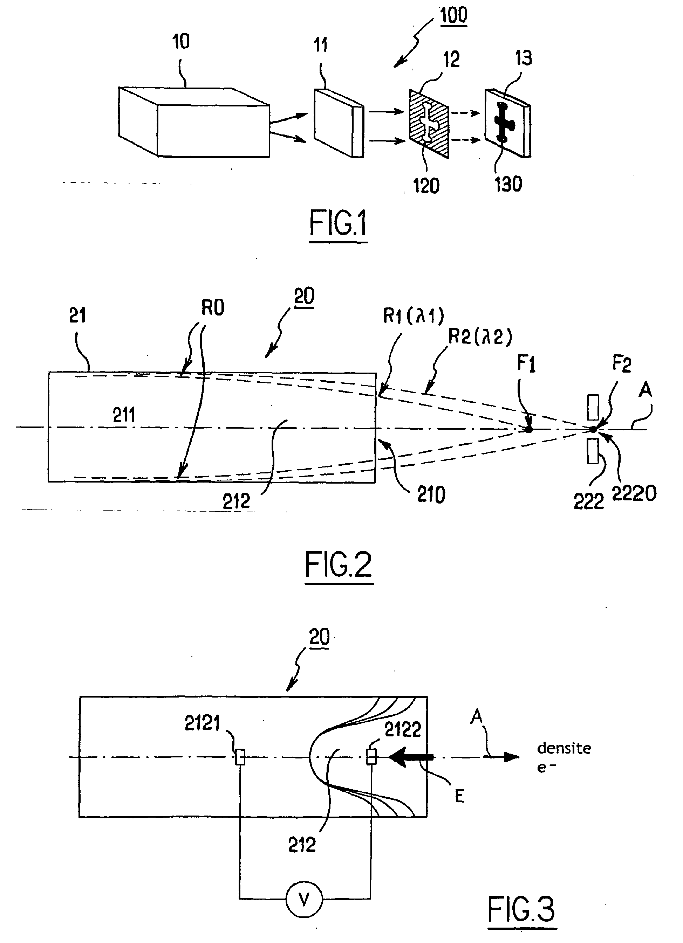

La figure 1 représente ainsi schématiquement un système optique 100, comprenant successivement :
- Un générateur 10 de rayonnement dans une gamme de longueurs d'onde désirées,
- Un ensemble de lentille 11 qui reçoit le rayonnement issu du générateur 10 et le traite (par exemple en lui appliquant une collimation et/ou une focalisation de ses rayons),
- Un masque 12 qui reçoit le rayonnement traité issu de l'ensemble de lentille, et n'en laisse passer sélectivement que les rayons arrivant sur la masque au niveau d'un motif 120 de transmission, le reste du rayonnement étant arrêté par le masque,
- Un substrat 13 qui reçoit les rayons ayant été transmis par le masque, et dont la surface exposée au rayonnement porte un produit photorésistif ou photosensible.

Les rayons arrivant sur le substrat réagissent avec le produit et forment ainsi sur la surface du substrat un motif correspondant au motif de transmission du masque.

La gamme de longueurs d'onde désirées du générateur 10 peut notamment être comprise dans le spectre ultra-violet (UV), ou dans le spectres extrême UV (EUV).

On précise que dans ce texte on désignera par convention par le terme « EUV » tant les rayons EUV que les rayons X mous.

Les rayons EUV sont associés à des longueurs d'onde très faibles (inférieures à 100 nm, par exemple de l'ordre de quelques dizaines de nm, une application correspondant à une longueur d'onde de 13,5 nm).

Ceci est avantageux notamment pour des applications en photolithographie, car de manière correspondante les motifs dessinés par les rayons peuvent être de très petites dimensions. Ceci permet notamment de former une plus grande quantité de motifs sur un substrat de même taille.

Il est cependant nécessaire d'associer au générateur de rayonnement des moyens de filtrage des rayons.

En effet, dans certains cas - notamment pour les générateurs de rayonnement d'une longueur d'onde du domaine EUV - le générateur comprend une source de rayonnement du type source à plasma.

Et de telles sources de rayonnement émettent, outre le rayonnement désiré :
- des rayonnements dont les longueurs d'onde ne correspondent pas à la gamme désirée, et/ou
- des débris solides issus de l'interaction entre le plasma et de parties solides de la chambre dans laquelle ce plasma se trouve (cible, parois de la chambre..).

Pour isoler dans le rayonnement issu de la source du générateur, uniquement les rayons de longueurs d'onde désirées, il est donc nécessaire de prévoir des moyens de filtrage en aval de la source (par exemple immédiatement en aval de la source, pour éviter d'exposer le masque à des débris qui pourraient l'endommager).

De manière connue, de tels moyens de filtrage comportent un miroir multicouche qui réfléchit sélectivement les rayons en fonction de leur longueur d'onde.

Un tel miroir multicouche fonctionne ainsi comme un filtre passe-bande.

Et il ne renvoie évidemment pas les débris indésirables qui peuvent être issus de la source, de sorte que les éléments se trouvant en aval des moyens de filtrage ne sont pas exposés à de tels débris.

Une telle solution permet effectivement de filtrer les rayons issus d'une source de rayonnement susceptible de produire des débris.

Mais un inconvénient associé à une telle configuration connue est que les débris issus de la source peuvent endommager le miroir des moyens de filtrage.

II serait certes possible d'envisager d'éloigner lesdits moyens de filtrage de la source, de manière à diminuer la probabilité qu'un débris endommage le miroir de ces moyens de filtrage.

Mais dans ce cas, on diminuerait sensiblement le flux de rayonnement récupéré par les moyens de filtrage, ce qui dégraderait les performances de tout le système optique.

EP-A2- 528 542 divulgue un procédé selon le préambule de la revendication 1 et un dispositif selon le préambule de la revendication 13.

Il apparaît ainsi que les configurations connues pour générer un rayonnement de longueurs d'onde désirées sont associées à des inconvénients, lorsque la source de rayonnement est susceptible de générer des débris.

Et cet inconvénient concerne notamment les applications dans lesquelles les longueurs d'onde désirées appartiennent au domaine EUV.

Le but de l'invention est de permettre de s'affranchir de ces inconvénients.

Afin d'atteindre ce but, l'invention propose selon un premier aspect un procédé de génération dans une direction d'émission d'un rayonnement dans une gamme de longueurs d'onde désirées, ledit procédé comprenant :
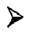 La production d'un rayonnement initial par une source de rayonnement, dont les longueurs d'onde incluent ladite gamme désirée,
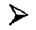 Le filtrage dudit rayonnement initial, de manière à substantiellement éliminer les rayons du rayonnement initial dont la longueur d'onde est hors de ladite gamme désirée, ledit filtrage étant réalisé en instaurant une répartition contrôlée d'indice de réfraction des rayons dans une région de contrôle traversée par le rayonnement initial, de manière à dévier sélectivement les rayons du rayonnement initial en fonction de leur longueur d'onde et à récupérer les rayons de longueurs d'onde désirées caractérisé en ce que ladite répartition contrôlée d'indice de réfraction des rayons est obtenue par le contrôle de la répartition de densité d'électrons dans ladite région de contrôle.

Des aspects préférés, mais non limitatifs d'un tel procédé sont les suivants :
• ladite région de contrôle est située dans un plasma,
• ledit plasma contenant ladite région de contrôle est lui-même contenu dans une chambre associée à ladite source de rayonnement,
• le contrôle de densité d'électrons est réalisé de manière à obtenir une densité d'électrons qui est plus importante à distance d'une ligne médiane d'émission du rayonnement initial que sur ladite ligne médiane d'émission du rayonnement initial,
• ladite ligne médiane d'émission du rayonnement initial est une ligne droite de rayonnement initial et ledit rayonnement initial est produit par ladite source de rayonnement avec une répartition sensiblement axisymétrique autour de ladite ligne droite de rayonnement initial,
• pour obtenir ladite répartition de densité d'électrons on effectue dans ledit plasma un apport d'énergie le long de ladite ligne médiane d'émission du rayonnement initial,
• ledit apport d'énergie est réalisé par ionisation du plasma le long de ladite ligne médiane d'émission du rayonnement initial,
• pour réaliser ladite ionisation on effectue les opérations suivantes :
   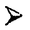 Etablissement d'une tension électrique aux bornes de la chambre contenant le plasma, lesdites bornes étant espacées selon la direction généralement définie par ladite ligne médiane d'émission du rayonnement initial,
   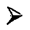 Application d'un faisceau énergétique au niveau de ladite ligne médiane d'émission du rayonnement initial,
• pour récupérer les rayons de longueurs d'onde désirées on dispose en aval de ladite région de contrôle au moins une fenêtre pour sélectivement laisser passer des rayons de la gamme de longueurs d'onde désirées,
• chaque fenêtre est disposée sur ladite ligne médiane d'émission du rayonnement initial, avec une abscisse curviligne correspondant au lieu d'intersection desdits rayons de la gamme de longueurs d'onde désirées qui ont été déviés avec ladite ligne médiane d'émission du rayonnement initial,
• ladite gamme de longueurs d'onde désirées est incluse dans l'intervalle [0-100 nm],
• ladite gamme de longueurs d'onde désirées est incluse dans le spectre EUV.

Selon un deuxième aspect, l'invention propose également un dispositif de génération dans une direction d'émission d'un rayonnement dans une gamme de longueurs d'onde désirées, ledit dispositif comprenant :
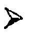 Une source de rayonnement initial dont les longueurs d'onde incluent ladite gamme désirée,
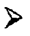 Des moyens de filtrage dudit rayonnement initial, de manière à substantiellement éliminer les rayons du rayonnement initial dont la longueur d'onde est hors de ladite gamme désirée,
lesdits moyens de filtrage comprenant des moyens pour instaurer une répartition contrôlée d'indice de réfraction des rayons dans une région de contrôle traversée par le rayonnement initial, de manière à dévier sélectivement les rayons du rayonnement initial en fonction de leur longueur d'onde et à récupérer les rayons de longueurs d'onde désirées caracterisé en ce que lesdits moyens pour instaurer une répartition contrôlée d'indice de réfraction comprennent des moyens pour contrôler la répartition de densité d'électrons dans ladite région de contrôle.

Des aspects préférés, mais non limitatifs d'un tel dispositif sont les suivants :
• ladite région de contrôle est située dans un plasma,
• ledit plasma contenant ladite région de contrôle est lui-même contenu dans une chambre associée à ladite source de rayonnement,
• lesdits moyens pour contrôler la répartition de densité d'électrons sont aptes à obtenir une densité d'électrons qui est plus importante à distance d'une ligne médiane d'émission du rayonnement initial que sur ladite ligne médiane d'émission du rayonnement initial,
• ladite ligne médiane d'émission du rayonnement initial est une ligne droite de rayonnement initial et lesdits moyens pour contrôler la répartition de densité d'électrons sont aptes à obtenir une densité d'électrons sensiblement axisymétrique autour de ladite ligne droite de rayonnement initial,
• lesdits moyens pour contrôler la répartition de densité d'électrons comprennent des moyens pour apporter dans ledit plasma une énergie le long de ladite ligne médiane d'émission du rayonnement initial,
• lesdits moyens pour apporter une énergie comprennent des moyens d'ionisation du plasma le long de ladite ligne médiane d'émission du rayonnement initial,
• lesdits moyens pour apporter une énergie comprennent des moyens pour :
   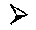 Etablir une tension électrique aux bornes de la chambre contenant le plasma, lesdites bornes étant espacées selon la direction généralement définie par ladite ligne médiane d'ém ission du rayonnement initial,
   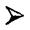 Appliquer un faisceau énergétique au niveau de ladite ligne médiane d'émission du rayonnement initial,
• le dispositif comporte en aval de ladite région de contrôle au moins une fenêtre pour sélectivement laisser passer des rayons de la gamme de longueurs d'onde désirées,
• chaque fenêtre est disposée sur ladite ligne médiane d'émission du rayonnement initial, avec une abscisse curviligne correspondant au lieu d'intersection desdits rayons de la gamme de longueurs d'onde désirées qui ont été déviés avec ladite ligne médiane d'émission du rayonnement initial,
• le dispositif comprend un miroir multicouche de filtrage additionnel en association avec au moins certaines fenêtres,
• le dispositif comprend une pluralité de modules qui comportent chacun une source de rayonnement initial et des moyens de filtrage associés, ainsi qu'un moyen optique permettant de recueillir les rayonnements faisant l'objet d'un filtrage pour les rediriger hors du dispositif.
• ledit moyen optique est un miroir multicouche qui est également apte à finaliser le filtrage desdits rayonnements,
• ladite gamme de longueurs d'onde désirées est incluse dans l'intervalle [0-100 nm],
• ladite gamme de longueurs d'onde désirées est incluse dans le spectre EUV.

Et l'invention concerne enfin un dispositif de lithographie comprenant un dispositif de génération selon un des aspects ci-dessus.

D'autres aspects, buts et avantages de l'invention apparaîtront mieux à la lecture de la description suivante de l'invention, faite en référence aux dessins annexés sur lesquels, outre la figure 1 qui a déjà été commentée ci-dessus :
- la figure 2 est un schéma de principe d'un générateur de rayonnement selon l'invention,
- la figure 3 est une représentation similaire, illustrant une répartition de densité d'électrons qui est contrôlée de manière particulière dans le cadre de l'invention,
- la figure 4 illustre un mode particulier de mise en oeuvre de l'invention avec une pluralité de source de rayonnement.

En référence à la figure 2, on a représenté schématiquement un générateur 20 de rayonnement selon l'invention.

Ce générateur de rayonnement comprend une chambre 21 qui est généralement fermée mais dont un côté 210 est ouvert pour laisser passer les rayons issus de la chambre.

La chambre 21 comporte une source 211 apte à produire un rayonnement initial R0.

Il s'agit typiquement d'une source contenant un plasma.

Le rayonnement initial comporte des rayons dont la longueur d'onde correspond à une gamme de longueurs d'onde désirées

Dans une application préférée mais non limitative de l'invention, la gamme de longueurs d'onde désirées est incluse dans l'intervalle [0-100 nm].

Cette gamme de longueurs d'onde désirées peut ainsi être incluse dans le spectre EUV.

La chambre 21 est ainsi apte à produire un rayonnement initial, dont une quantité significative de rayons correspondent à la gamme de longueurs d'onde désirées.

Comme cela a été mentionné, il est toutefois possible que des effets indésirables soient associés à l'émission de la source :
- le rayonnement initial peut également contenir des rayons dont les longueurs d'onde ne correspondent pas exactement à la gamme désirée,
- et il est aussi possible que la source 211 émette certains débris avec le rayonnement initial.

Pour prévenir ces effets indésirables, le générateur 20 comprend des moyens de filtrage du rayonnement initial.

Et ces moyens de filtrage sont aptes à instaurer une répartition contrôlée d'indice de réfraction des rayons, dans une région de contrôle 212 traversée par le rayonnement initial, de manière à dévier sélectivement les rayons du rayonnement initial en fonction de leur longueur d'onde.

On récupère ensuite (notamment par les moyens qui vont être décrits dans ce texte) les rayons de longueurs d'onde désirées.

On exploite ainsi un principe physique analogue à celui qui provoque par exemple la déviation de rayons lumineux en présence d'un gradient d'indice de réfraction de l'air (cas notamment d'un air présentant de forts gradients de température).

La région de contrôle est dans le cas de la représentation de la figure 2 située à l'intérieur même de la chambre 21.

On précise qu'il est également possible que cette région de contrôle soit située en dehors de la chambre 21, en aval de celle-ci sur le trajet du rayonnement initial.

Le contrôle de la répartition d'indice de réfraction dans la région de contrôle peut être obtenu en contrôlant la répartition de densité d'électrons dans ladite région de contrôle.

A cet égard, il est en effet possible d'exploiter la relation liant l'indice de réfraction η à la densité d'électrons nₑ :
η = (1 - nₑ/n_{c})^{1/2} (avec n_{c} représentant une valeur de densité d'électrons critique au-delà de laquelle les rayons ne peuvent plus passer - cette valeur de n_{c} étant liée à la longueur d'onde des rayons considérés).

Revenant au mode de réalisation illustré sur la figure 2, la région de contrôle 212 est donc située dans la chambre 21, et cette région de contrôle est ainsi dans le plasma associé à la source 211.

Le contrôle de la répartition de la densité d'électrons dans la région de contrôle permet d'influer sur les trajectoires des différents rayons du rayonnement initial, en fonction de la longueur d'onde de ces rayons.

Ceci est illustré sur la figure 2, qui montre deux trajectoires générales de deux types de rayons :
- des rayons d'une première longueur d'onde λ1. Ces rayons ont une trajectoire R1,
- des rayons d'une deuxième longueur d'onde λ2, qui est inférieure à la première longueur d'onde λ1. Ces rayons ont une trajectoire R2.

Dans l'application préférée de l'invention qui est ici illustrée on établit dans la région de contrôle une répartition de densité d'électrons telle que la densité d'électrons est plus importante à distance d'une ligne médiane d'émission du rayonnement initial que sur ladite ligne médiane d'émission du rayonnement initial.

La « ligne médiane d'émission du rayonnement initial » correspond dans le cas de la figure 2 à la ligne droite A. On précise que dans le cas illustré ici, la chambre a typiquement une forme de cylindre rond et que le rayonnement initial est émis avec une répartition sensiblement axisymétrique des rayons, autour de la ligne A.

La configuration de la répartition de densité d'électrons désirée dans ce cas est illustrée de manière schématique sur la figure 3, qui présente des courbes de densité d'électrons.

On constate sur cette figure que la valeur de densité d'électrons est plus importante sur les bords de la chambre (à distance de la ligne A) qu'au milieu de cette chambre (près de la ligne A).

On constate également que les trois courbes de densité d'électrons qui sont représentées divergent dans la région périphérique de la chambre. On reviendra sur cet aspect.

On notera qu'une telle répartition de densité d'électrons est opposée à la répartition de densité d'électrons que l'on peut normalement observer dans la chambre d'une source de rayonnement.

Dans le cas d'une chambre de type connu en effet, on observe généralement une densité supérieure au centre de la chambre.

La configuration de densité représentée sur la figure 3 est ainsi spécifique, et elle est créée à dessein pour l'application de l'invention que l'on décrit ici.

Pour créer une telle répartition de densité d'électrons dans la région de contrôle, on apporte dans le plasma de la chambre 21 une énergie le long de ladite ligne A.

Cet apport d'énergie peut être effectué par exemple par un faisceau d'électrons ou par un rayon laser, dirigé dans la région de contrôle selon l'axe défini par la ligne A.

Cet apport d'énergie est illustré de manière schématique par la flèche E.

Il permet d'ioniser le plasma dans la région de contrôle, le long de la ligne A.

Préalablement à cet apport d'énergie, on a pu établir une tension électrique à des bornes de la chambre contenant le plasma, lesdites bornes étant espacées selon la direction généralement définie par ladite ligne médiane d'émission du rayonnement initial.

La figure 3 représente schématiquement de telles bornes 2121 et 2122.

Et il est ainsi possible de créer une répartition de densité d'électrons du type de celles représentées sur la figure 3.

On précise qu'une telle répartition peut être obtenue en partant d'une répartition de densité de type connue, dans laquelle la densité est supérieure au centre de la chambre.

L'apport d'énergie et l'ionisation qui lui est associée permet en effet dans ce cas de « renverser » la configuration de densité, et d'obtenir une densité supérieure près des parois périphériques de la chambre.

La figure 3 présente comme on l'a dit trois courbes de répartition de densité.

Ces trois courbes sont sensiblement confondues dans la région centrale de la chambre (près de la ligne A), mais correspondent à des valeurs différentes de densité près des parois de la chambre.

Ces trois courbes correspondent à des états successifs de la répartition de densité d'électrons, lorsqu'une ionisation de la zone centrale de la région de contrôle a été effectuée.

A l'issue d' une telle ionisation, on trouve une densité d'électrons qui est déjà supérieure en périphérie de la région de contrôle.

Mais si on laisse ensuite évoluer le plasma qui a ainsi été ionisé, cette configuration va ensuite s'accentuer, et la valeur de la densité va encore croître en périphérie.

En effet, les électrons de haute densité présents en grande quantité à la périphérie de la chambre vont avoir tendance à faire fondre les parois internes de cette chambre, monocouche de revêtement de paroi par monocouche de revêtement de paroi.

II résultera de cette fusion un apport supplémentaire d'électrons en périphérie de la chambre, ce qui augmentera encore la densité d'électrons à ce niveau.

En référence spécifiquement à la figure 2, on a représenté une fenêtre 222 qui est disposée au point focal des rayons de trajectoire R2.

Cette fenêtre correspond à un moyen de récupération des rayons de longueurs d'onde désirées, parmi les rayons du rayonnement initial.

On a vu que les différents rayons issus du rayonnement initial R0 étaient déviés de manière différente par la répartition de densité d'électrons qui régnait dans la région de contrôle, en fonction de leur longueur d'onde.

Cette déviation sélective amène les rayons associés à une longueur d'onde donnée à converger vers un point spécifique de la ligne A - et on désignera ce point spécifique par « point focal ».

La position du point focal sur la ligne A (position pouvant être définie par une abscisse curviligne d'un repère lié à ladite ligne A) dépend ainsi de la longueur d'onde associée à ce point focal.

On a représenté sur la figure 2 les points focaux F1 et F2 associés respectivement aux rayons des trajectoires R1 et R2.

La fenêtre 222 est ainsi disposée au point focal F2.

Cette fenêtre a pour fonction de ne laisser passer que les rayons arrivant sur la ligne A sensiblement au niveau du point focal F2 (c'est à dire les rayons de longueur d'onde λ2). A cet effet, la fenêtre 222 comporte une ouverture 2220 qui est de préférence centrée sur la ligne A.

Cette fenêtre constitue ainsi un moyen avantageux pour récupérer uniquement les rayons de longueurs d'onde désirées ; elle améliore ainsi le filtrage des rayons issus du rayonnement initial.

Et on peut de la sorte disposer des fenêtres en tout emplacement désiré de la ligne A, en fonction de la longueur d'onde que l'on désire isoler.

On comprend donc que l'invention permet d'isoler de manière efficace des rayons d'une longueur d'onde désirée (ou de longueurs d'onde désirées, en toute rigueur).

Et dans le cas de l'invention, on n'expose pas un moyen de filtrage tel qu'un miroir multicouche à des débris susceptibles de l'endommager.

Dans le cas de l'invention, le fait de récupérer les rayons désirés en un point spécifique vers lequel ils ont été déviés permet déjà de s'affranchir d'une part importante des éventuels débris. issus de la source 21.

Et la mise en oeuvre de moyens de récupération tels qu'une fenêtre permet de réduire encore le nombre de ces débris.

Il en résulte qu'à l'issue de ce filtrage, il ne se trouve plus du tout de débris - ou seulement un nombre très réduit.

On précise qu'il est possible de disposer en aval du point focal des rayons que l'on désire récupérer des moyens de conditionnement optique du faisceau formé par ces rayons filtrés.

Le conditionnement optique peut être en particulier une collimation et/ou une focalisation.

On peut ainsi diriger le faisceau récupéré directement vers un masque de lithographie.

Il est également possible de diriger le faisceau récupéré vers des moyens de filtrage supplémentaires, si cela est désiré.

De tels moyens de filtrage supplémentaires peuvent comprendre un miroir multicouche tel que ceux qui constituent les moyens de filtrage connus actuellement.

Les couches d'un tel miroir multicouche sont définies (composition, et épaisseur) pour que le miroir réfléchisse sélectivement uniquement les rayons d'une longueur d'onde donnée (en fonction d'une condition dite de Bragg qui lie la réflectivité du miroir à la longueur d'onde des rayon,s incidents).

Dans cette variante, on utilise en série plusieurs moyens de filtrage. Et le moyen le plus amont qui met en oeuvre une déviation sélective de rayons et leur récupération permet alors de protéger le moyen le plus aval (miroir multicouche) des débris issus de la source.

On précise enfin qu'il est possible de mettre en oeuvre l'invention dans un dispositif comprenant une pluralité de sources de rayonnement initial, chacune associée à des moyens permettant de contrôler une répartition d'indice de réfraction dans une région de contrôle associée.

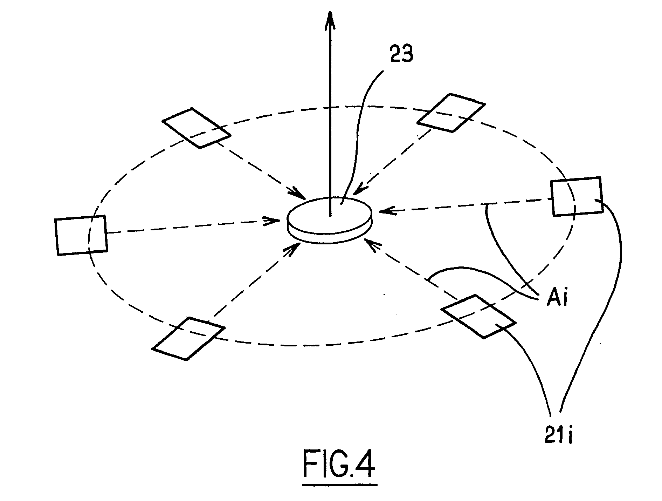

Ce mode de mise en oeuvre est illustré schématiquement sur la figure 4.

Sur cette figure, une pluralité de chambres 21i qui sont analogues à la chambre 21 déjà décrite dirigent leurs rayonnements respectifs selon des lignes médianes respectives Ai, qui convergent vers une optique centrale 23.

L'optique centrale peut ainsi recevoir les rayons issus d'une ou plusieurs chambres 21 i, en fonction des chambres qui sont actives.

La distance entre l'optique 23 et chaque chambre est ajustée pour sélectionner la longueur d'onde de filtrage de rayonnement associée à chaque chambre active.

Il est d'ailleurs ainsi possible de faire arriver sur l'optique 23 des rayons de différentes longueurs d'onde, provenant de différentes chambres.

En tout état de cause, l'optique 23 est apte à rediriger les rayons reçus vers l'extérieur - par exemple vers d'autres moyens de traitement optique (tels qu'un masque de lithographie).

## Revendications

1. Procédé de génération dans une direction d'émission d'un rayonnement dans une gamme de longueurs d'onde désirées, ledit procédé comprenant :
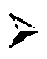 La production d'un rayonnement initial par une source de rayonnement, dont les longueurs d'onde incluent ladite gamme désirée,
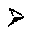 Le filtrage dudit rayonnement initial, de manière à substantiellement éliminer les rayons du rayonnement initial dont la longueur d'onde est hors de ladite gamme désirée,
ledit filtrage étant réalisé en instaurant une répartition contrôlée d'indice de réfraction des rayons dans une région de contrôle traversée par le rayonnement initial, de manière à dévier sélectivement les rayons du rayonnement initial en fonction de leur longueur d'onde et à récupérer les rayons de longueurs d'onde désirées **caractérisé en ce que** ladite répartition contrôlée d'indice de réfraction des rayons est obtenue par le contrôle de la répartition de densité d'électrons dans ladite région de contrôle.

2. Procédé selon la revendication précédente, **caractérisé en ce que** ladite région de contrôle est située dans un plasma.

3. Procédé selon la revendication précédente, **caractérisé en ce que** ledit plasma contenant ladite région de contrôle est lui-même contenu dans une chambre associée à ladite source de rayonnement.

4. Procédé selon l'une des deux revendications précédentes, **caractérisé en ce que** le contrôle de densité d'électrons est réalisé de manière à obtenir une densité d'électrons qui est plus importante à distance d'une ligne médiane d'émission du rayonnement initial que sur ladite ligne médiane d'émission du rayonnement initial.

5. Procédé selon la revendication précédente, **caractérisé en ce que** ladite ligne médiane d'émission du rayonnement initial est une ligne droite de rayonnement initial et ledit rayonnement initial est produit par ladite source de rayonnement avec une répartition sensiblement axisymétrique autour de ladite ligne droite de rayonnement initial.

6. Procédé selon la revendication précédente, **caractérisé en ce que** pour obtenir ladite répartition de densité d'électrons on effectue dans ledit plasma un apport d'énergie le long de ladite ligne médiane d'émission du rayonnement initial.

7. Procédé selon la revendication précédente, **caractérisé en ce que** ledit apport d'énergie est réalisé par ionisation du plasma le long de ladite ligne médiane d'émission du rayonnement initial.

8. Procédé selon la revendication précédente, **caractérisé en ce que** pour réaliser ladite ionisation on effectue les opérations suivantes :
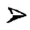 Etablissement d'une tension électrique aux bornes de la chambre contenant le plasma, lesdites bornes étant espacées selon la direction généralement définie par ladite ligne médiane d'émission du rayonnement initial,
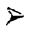 Application d'un faisceau énergétique au niveau de ladite ligne médiane d'émission du rayonnement initial.

9. Procédé selon l'une des revendications précédentes, **caractérisé en ce que** pour récupérer les rayons de longueurs d'onde désirées on dispose en aval de ladite région de contrôle au moins une fenêtre pour sélectivement laisser passer des rayons de la gamme de longueurs d'onde désirées.

10. Procédé selon la revendication précédente, **caractérisé en ce que** chaque fenêtre est disposée sur ladite ligne médiane d'émission du rayonnement initial, avec une abscisse curviligne correspondant au lieu d'intersection desdits rayons de la gamme de longueurs d'onde désirées qui ont été déviés avec ladite ligne médiane d'émission du rayonnement initial.

11. Procédé selon l'une des revendications précédentes, **caractérisé en ce que** ladite gamme de longueurs d'onde désirées est incluse dans l'intervalle [0-100 nm].

12. Procédé selon la revendication précédente, **caractérisé en ce que** ladite gamme de longueurs d'onde désirées est incluse dans le spectre EUV.

13. Dispositif de génération dans une direction d'émission d'un rayonnement dans une gamme de longueurs d'onde désirées, ledit dispositif comprenant :
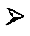 Une source de rayonnement initial dont les longueurs d'onde incluent ladite gamme désirée,
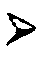 Des moyens de filtrage dudit rayonnement initial, de manière à substantiellement éliminer les rayons du rayonnement initial dont la longueur d'onde est hors de ladite gamme désirée,
lesdits moyens de filtrage comprenant des moyens pour instaurer une répartition contrôlée d'indice de réfraction des rayons dans une région de contrôle traversée par le rayonnement initial, de manière à dévier sélectivement les rayons du rayonnement initial en fonction de leur longueur d'onde et à récupérer les rayons de longueurs d'onde désirées, **caractérisé en ce que** lesdits moyens pour instaurer une répartition contrôlée d'indice de réfraction comprennent des moyens pour contrôler la répartition de densité d'électrons dans ladite région de contrôle.

14. Dispositif selon la revendication précédente, **caractérisé en ce que** ladite région de contrôle est située dans un plasma.

15. Dispositif selon la revendication précédente, **caractérisé en ce que** ledit plasma contenant ladite région de contrôle est lui-même contenu dans une chambre associée à ladite source de rayonnement.

16. Dispositif selon l'une des deux revendications précédentes, **caractérisé en ce que** lesdits moyens pour contrôler la répartition de densité d'électrons sont aptes à obtenir une densité d'électrons qui est plus importante à distance d'une ligne médiane d'émission du rayonnement initial que sur ladite ligne médiane d'émission du rayonnement initial.

17. Dispositif selon la revendication précédente, **caractérisé en ce que** ladite ligne médiane d'émission du rayonnement initial est une ligne droite de rayonnement initial et lesdits moyens pour contrôler la répartition de densité d'électrons sont aptes à obtenir une densité d'électrons sensiblement axisymétrique autour de ladite ligne droite de rayonnement initial.

18. Dispositif selon la revendication précédente, **caractérisé en ce que** lesdits moyens pour contrôler la répartition de densité d'électrons comprennent des moyens pour apporter dans ledit plasma une énergie le long de ladite ligne médiane d'émission du rayonnement initial.

19. Dispositif selon la revendication précédente, **caractérisé en ce que** lesdits moyens pour apporter une énergie comprennent des moyens d'ionisation du plasma le long de ladite ligne médiane d'émission du rayonnement initial.

20. Dispositif selon la revendication précédente, **caractérisé en ce que** lesdits moyens pour apporter une énergie comprennent des moyens pour :
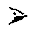 Etablir une tension électrique aux bornes de la chambre contenant le plasma, lesdites bornes étant espacées selon la direction généralement définie par ladite ligne médiane d'émission du rayonnement initial,
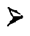 Appliquer un faisceau énergétique au niveau de ladite ligne médiane d'émission du rayonnement initial.

21. Dispositif selon l'une des huit revendications précédentes, **caractérisé en ce que** le dispositif comporte en aval de ladite région de contrôle au moins une fenêtre pour sélectivement laisser passer des rayons de la gamme de longueurs d'onde désirées.

22. Dispositif selon la revendication précédente, **caractérisé en ce que** chaque fenêtre est disposée sur ladite ligne médiane d'émission du rayonnement initial, avec une abscisse curviligne correspondant au lieu d'intersection desdits rayons de la gamme de longueurs d'onde désirées qui ont été déviés avec ladite ligne médiane d'émission du rayonnement initial.

23. Dispositif selon l'une des deux revendications précédentes, **caractérisé en ce que** le dispositif comprend un miroir multicouche de filtrage additionnel en association avec au moins certaines fenêtres.

24. Dispositif selon la revendication précédente, **caractérisé en ce que** le dispositif comprend une pluralité de modules qui comportent chacun une source de rayonnement initial et des moyens de filtrage associés, ainsi qu'un moyen optique permettant de recueillir les rayonnements faisant l'objet d'un filtrage pour les rediriger hors du dispositif.

25. Dispositif selon la revendication précédente, **caractérisé en ce que** ledit moyen optique est un miroir multicouche qui est également apte à finaliser le filtrage desdits rayonnements.

26. Dispositif selon l'une des treize revendications précédentes, **caractérisé en ce que** ladite gamme de longueurs d'onde désirées est incluse dans l'intervalle [0-100 nm].

27. Dispositif selon la revendication précédente, **caractérisé en ce que** ladite gamme de longueurs d'onde désirées est incluse dans le spectre EUV.

28. Dispositif de lithographie comprenant un dispositif de génération selon une des quinze revendications précédentes.

## Claims

1. Process for generation of radiation in a range of desired wavelengths in an emission direction, said process comprising:
- production of initial radiation by a radiation source for which wavelengths include the desired range,
- filtering of said initial radiation so as to substantially eliminate rays of the initial radiation for which the wavelength is outside said desired range,
said filtering being done by setting up a controlled distribution of refractive indices of rays in a control region through which the initial radiation passes, so as to selectively deviate the rays in the initial radiation as a function of their wavelength, and to recover rays with the desired wavelengths,
**characterised in that** said controlled distribution of refractive index of rays is obtained by controlling the density distribution of electrons in said control region.

2. Process according to the above claim, **characterised in that** said control region is located in a plasma.

3. Process according to the above claim, **characterised in that** said plasma containing the control region is itself contained in a chamber associated with said radiation source.

4. Process according to one of the above two claims, **characterised in that** the electron density is controlled so as to obtain an electron density that is greater at a distance from a median emission line of the initial radiation than on said median emission line of the initial radiation.

5. Process according to the above claim, **characterised in that** said median emission line of the initial radiation is a straight line of initial radiation and said initial radiation is produced by said radiation source with a substantially axisymmetric distribution around said straight line of initial radiation.

6. Process according to the above claim, **characterised in that** said electron density distribution is obtained by inputting energy into said plasma along said median emission line of the initial radiation.

7. Process according to the above claim, **characterised in that** said energy is input by ionisation of plasma along said median emission line of the initial radiation.

8. Process according to the above claim, **characterised in that** the following operations are done to achieve said ionisation:
- establishing a voltage on the terminals of the chamber containing the plasma, said terminals being spaced along the direction generally defined by said median emission line of the initial radiation,
- application of an energy beam at said median emission line of the initial radiation.

9. Process according to one of the above claims, **characterised in that** to recover rays with the desired wavelengths, there is at least one window on the downstream side of said control region to selectively allow rays with the desired wavelength range to pass.

10. Process according to the above claim, **characterised in that** each window is located on said median emission line of the initial radiation, with a curvilinear abscissa corresponding to the intersection location of said rays in the range of desired wavelengths that have been deviated with said median emission line of the initial radiation.

11. Process according to one of the above claims, **characterised in that** said range of desired wavelengths is included in the interval [0 - 100 nm].

12. Process according to the above claim, **characterised in that** said range of desired wavelengths is included in the EUV spectrum.

13. Device for generation of radiation in a range of desired wavelengths in an emission direction, said device comprising:
- a source of initial radiation for which the wavelengths include said desired range,
- filtering means for said initial radiation, so as to substantially eliminate the rays of the initial radiation for which the wavelength is outside the desired range,
said filtering means comprising means for setting up a controlled distribution of refractive indices of rays in a control region through which the initial radiation passes, so as to selectively deviate rays of the initial radiation as a function of their wavelength and to recover rays with the desired wavelengths,
**characterised in that** said means for setting up a controlled distribution of refractive indices comprise means for controlling the electron density distribution in said control region.

14. Device according to the above claim, **characterised in that** said control region is located in a plasma.

15. Device according to the above claim, **characterised in that** said plasma containing said control region is itself contained in a chamber associated with said radiation source.

16. Device according to one of the above two claims, **characterised in that** said means for controlling the electron density distribution are capable of obtaining an electron density that is greater at a distance from a median emission line of the initial radiation than on said median emission line of the initial radiation.

17. Device according to the above claim, **characterised in that** said median emission line of the initial radiation is a straight line of initial radiation and said means for controlling the electron density distribution are capable of obtaining an electron density that is substantially axisymmetric around said straight line of initial radiation.

18. Device according to the above claim, **characterised in that** said means for controlling the electron density distribution comprise means for inputting energy into said plasma along said median emission line of the initial radiation.

19. Device according to the above claim, **characterised in that** said means for inputting energy comprise means for ionisation of plasma along said median emission line of the initial radiation.

20. Device according to the above claim, **characterised in that** said means for supplying energy comprise means for:
- setting up a voltage on the terminals of the chamber containing the plasma, said terminals being spaced along the direction generally defined by said median emission line of the initial radiation,
- applying an energy beam at said median emission line of the initial radiation.

21. Device according to one of the above eight claims, **characterised in that** the device comprises at least one window on the downstream side of said control region, for selectively allowing rays in the range of desired wavelengths to pass.

22. Device according to the above claim, **characterised in that** each window is located on said median emission line of the initial radiation, with a curved abscissa corresponding to the location of the intersection of said rays in the range of desired wavelengths that have been deviated with said median emission line of the initial radiation.

23. Device according to one of the above two claims, **characterised in that** the device comprises an additional multi-layer filtering mirror associated at least with certain windows.

24. Device according to the above claim, **characterised in that** the device comprises a plurality of modules, each comprising a source of initial radiation and associated filtering means, as well as an optical means enabling collection of the filtered radiation, to redirect them outside the device.

25. Device according to the above claim, **characterised in that** said optical means is a multilayer mirror that is also capable of finalising the filtering of said radiation.

26. Device according to the above thirteen claims, **characterised in that** said range of desired wavelengths is included in the interval [0 - 100 nm ].

27. Device according to the above claim, **characterised in that** said range of desired wavelengths is included in the EUV spectrum.

28. Lithography device comprising a generating device according to one of the above fifteen claims.

## Patentansprüche

1. Verfahren zur Erzeugung einer Strahlung in einer Ausstrahlungsrichtung und in einem gewünschten Wellenlängenbereich, aufweisend:
- die Erzeugung einer Anfangsstrahlung mittels einer Strahlungsquelle, deren Wellenlängen den gewünschten Bereich enthalten,
- die Filterung der Anfangsstrahlung, derart, um im wesentlichen diejenigen Strahlen der Anfangsstrahlung zu eliminieren, deren Wellenlänge außerhalb des gewünschten Bereichs ist,
wobei die Filterung **dadurch** erfolgt, daß eine gesteuerte Verteilung des Brechungsindexes der Strahlen in einen von der Anfangsstrahlung durchquerten Steuerbereich vorgesehen wird, um die Strahlen der Anfangsstrahlung in Abhängigkeit von ihrer Wellenlänge selektiv abzulenken und die Strahlen mit den gewünschten Wellenlängen zu gewinnen,
**dadurch gekennzeichnet, daß** die gesteuerte Verteilung des Brechungsindexes der Strahlen durch die Steuerung der Elektronendichteverteilung in dem Steuerbereich erzielt wird.

2. Verfahren nach dem vorstehenden Anspruch, **dadurch gekennzeichnet, daß** der Steuerbereich in einem Plasma angeordnet ist.

3. Verfahren nach dem vorstehenden Anspruch, **dadurch gekennzeichnet, daß** das Plasma, das den Steuerbereich enthält, seinerseits in einer der Strahlungsquelle zugeordneten Kammer angeordnet ist.

4. Verfahren nach einem von zwei vorstehenden Ansprüche, **dadurch gekennzeichnet, daß** die Steuerung der Elektronendichte auf eine Weise erfolgt, um eine Elektronendichte zu erzielen, die im Abstand zu einer zentralen Ausbreitungslinie der Anfangsstrahlung größer ist als an der zentralen Ausbreitungslinie der Anfangsstrahlung.

5. Verfahren nach dem vorstehenden Anspruch, **dadurch gekennzeichnet, daß** die zentrale Ausbreitungslinie der Anfangsstrahlung eine gerade Anfangsstrahlungslinie ist und die Anfangsstrahlung von der Strahlungsquelle mit einer im wesentlichen achsensymmetrischen Verteilung um die gerade Anfangsstrahlungslinie erzeugt wird.

6. Verfahren nach dem vorstehenden Anspruch, **dadurch gekennzeichnet, daß** zur Erzeugung der Elektronendichteverteilung dem Plasma entlang der zentralen Ausbreitungslinie der Anfangsstrahlung Energie zugeführt wird.

7. Verfahren nach dem vorstehenden Anspruch, **dadurch gekennzeichnet, daß** die Energiezufuhr durch Ionisation des Plasmas entlang der zentralen Ausbreitungslinie der Anfangsstrahlung erfolgt.

8. Verfahren nach dem vorstehenden Anspruch, **dadurch gekennzeichnet, daß** zur Durchführung der Ionisation folgende Schritte durchgeführt werden:
- Aufbauen einer elektrischen Spannung an den Anschlußklemmen der das Plasma enthaltenden Kammer, wobei die Anschlußklemmen entlang der durch die zentrale Ausbreitungslinie der Anfangsstrahlung allgemein definierten Richtung beabstandet sind,
- Anwenden eines energetischen Bündels am Ort der zentralen Ausbreitungslinie der Anfangsstrahlung.

9. Verfahren nach einem der vorstehenden Ansprüche, **dadurch gekennzeichnet, daß**, um die Strahlen mit den gewünschten Wellenlängen zu gewinnen, nach dem Steuerbereich mindestens ein Fenster angeordnet ist, um die Strahlen des gewünschten Wellenbereichs selektiv hindurchgehen zu lassen.

10. Verfahren nach dem vorstehenden Anspruch, **dadurch gekennzeichnet, daß** jedes Fenster auf der zentralen Ausbreitungslinie der Anfangsstrahlung angeordnet ist, mit einer gekrümmten Abszisse, die dem Schnittort der Strahlen des gewünschten Wellenlängenbereichs, die abgelenkt worden sind, mit der zentralen Ausbreitungslinie der Anfangsstrahlung entspricht.

11. Verfahren nach einem der vorstehenden Ansprüche, **dadurch gekennzeichnet, daß** der gewünschte Wellenlängenbereich in dem Intervall [0-100nm] enthalten ist.

12. Verfahren nach dem vorstehenden Anspruch, **dadurch gekennzeichnet, daß** der gewünschte Wellenlängenbereich in dem EUV-Spektrum liegt.

13. Vorrichtung zur Erzeugung einer Strahlung in einer Ausbreitungsrichtung und in einem gewünschten Wellenlängenbereich, wobei die Vorrichtung aufweist:
- eine Quelle einer Anfangsstrahlung, deren Wellenlängen den gewünschten Bereich enthalten,
- Filtereinrichtungen zum Filtern der Anfangsstrahlung, um im wesentlichen diejenigen Strahlen der Anfangsstrahlung zu eliminieren, deren Wellenlänge außerhalb des gewünschten Bereichs ist,
wobei die Filtereinrichtungen Einrichtungen aufweisen, um eine gesteuerte Verteilung des Brechungsindexes der Strahlen in einen von der Anfangsstrahlung durchquerten Bereich vorzusehen, um die Strahlen der Anfangsstrahlung in Abhängigkeit von ihrer Wellenlänge selektiv abzulenken und die Strahlen mit den gewünschten Wellenlängen zu gewinnen,
**dadurch gekennzeichnet, daß** die Einrichtungen zum Vorsehen einer gesteuerten Verteilung des Brechungsindexes aufweisen: Einrichtungen zur Steuerung der Elektronendichteverteilung in dem Steuerbereich.

14. Vorrichtung nach dem vorstehenden Anspruch, **dadurch gekennzeichnet, daß** der Steuerbereich in einem Plasma angeordnet ist.

15. Vorrichtung nach dem vorstehenden Anspruch, **dadurch gekennzeichnet, daß** das Plasma, das den Steuerbereich enthält, seinerseits in einer der Strahlungsquelle zugeordneten Kammer angeordnet ist.

16. Vorrichtung nach einem von zwei vorstehenden Ansprüche, **dadurch gekennzeichnet, daß** die Einrichtungen zur Steuerung der Elektronendichteverteilung in der Lage sind, eine Elektronendichte zu erzielen, die im Abstand zu einer zentralen Ausbreitungslinie der Anfangsstrahlung größer ist als an der zentralen Ausbreitungslinie der Anfangsstrahlung.

17. Vorrichtung nach dem vorstehenden Anspruch, **dadurch gekennzeichnet, daß** die zentrale Ausbreitungsachse der Anfangsstrahlung eine gerade Anfangsstrahlungslinie ist und die Einrichtungen zur Steuerung der Elektronendichteverteilung in der Lage sind, eine um die gerade Anfangsstrahlungslinie im wesentlichen achsensymmetrische Elektronendichte zu erzeugen.

18. Vorrichtung nach dem vorstehenden Anspruch, **dadurch gekennzeichnet, daß** die Einrichtungen zur Steuerung der Elektronendichteverteilung Einrichtungen zum Zuführen von Energie entlang der zentralen Ausbreitungslinie der Anfangsstrahlung in das Plasma aufweisen.

19. Vorrichtung nach dem vorstehenden Anspruch, **dadurch gekennzeichnet, daß** die Einrichtungen zur Energiezufuhr Einrichtungen zur Ionisation des Plasmas entlang der zentralen Ausbreitungslinie der Anfangsstrahlung aufweisen.

20. Vorrichtung nach dem vorstehenden Anspruch, **dadurch gekennzeichnet, daß** die Einrichtungen zur Energiezufuhr aufweisen:
- Einrichtungen zum Aufbauen einer elektrischen Spannung an den Anschlußklemmen der das Plasma enthaltenden Kammer, wobei die Anschlußklemmen entlang der durch die zentrale Ausbreitungslinie der Anfangsstrahlung allgemein definierten Richtung beabstandet sind,
- Einrichtungen zum Anwenden eines energetischen Bündels am Ort der zentralen Ausbreitungslinie der Anfangsstrahlung.

21. Vorrichtung nach einem der acht vorstehenden Ansprüche, **dadurch gekennzeichnet, daß** die Vorrichtung nach dem Steuerbereich mindestens ein Fenster aufweist, um die Strahlen des gewünschten Wellenbereichs selektiv hindurchgehen zu lassen.

22. Vorrichtung nach dem vorstehenden Anspruch, **dadurch gekennzeichnet, daß** jedes Fenster auf der zentralen Ausbreitungslinie der Anfangsstrahlung angeordnet ist, mit einer gekrümmten Abszisse, die dem Schnittort der Strahlen des gewünschten Wellenlängenbereichs, die abgelenkt worden sind, mit der zentralen Ausbreitungslinie der Anfangsstrahlung entspricht.

23. Vorrichtung nach einem der zwei vorstehenden Ansprüche, **dadurch gekennzeichnet, daß** die Vorrichtung einen zusätzlichen mehrschichtigen Filterspiegel in Verbindung mit mindestens einigen Fenstern aufweist.

24. Vorrichtung nach dem vorstehenden Anspruch, **dadurch gekennzeichnet, daß** die Vorrichtung mehrere Module aufweist, die jeweils eine Anfangsstrahlungsquelle und zugehörige Filtereinrichtungen aufweisen, sowie eine optische Einrichtung aufweist, die erlaubt, die einer Filterung unterworfenen Strahlen zu sammeln, um sie aus der Vorrichtung hinaus zu lenken.

25. Vorrichtung nach dem vorstehenden Anspruch, **dadurch gekennzeichnet, daß** die optische Einrichtung ein mehrschichtiger Spiegel ist, der auch in der Lage ist, eine Endfilterung der Strahlen auszuführen.

26. Vorrichtung nach einem der dreizehn vorstehenden Ansprüche, **dadurch gekennzeichnet, daß** der gewünschte Wellenlängenbereich in dem Intervall [0-100nm] liegt.

27. Vorrichtung nach dem vorstehenden Anspruch, **dadurch gekennzeichnet, daß** der gewünschte Wellenlängenbereich in dem EUV-Spektrum liegt.

28. Lithographie-Vorrichtung mit einer Erzeugungsvorrichtung gemäß einem der fünfzehn vorstehenden Ansprüche.
